# EUROPEAN PATENT APPLICATION

(11) **EP 4 187 595 A1**
(43) Date of publication of application: **31.05.2023**
(21) Application number: 21211006.8
(22) Date of filing: 29.11.2021
(51) Int. Cl.: H01L 23/498, H01L 23/053

(54) **TERMINAL ELEMENT OR BUS BAR, AND POWER SEMICONDUCTOR MODULE ARRANGEMENT COMPRISING A TERMINAL ELEMENT OR BUS BAR**

(71) Applicant: Infineon Technologies AG, 85579 Neubiberg (DE)
(72) Inventor: UNRAU, Arthur, 59590 Geseke (DE); DREPS, Florian, 33102 Paderborn (DE); KOCH, Christoph, 33154 Salzkotten (DE); NEDDERMANN, Till, 59872 Meschede (DE); STEININGER, Christian, 59494 Soest (DE)
(74) Representative: Westphal, Mussgnug & Partner, Patentanwälte mbB

(57) **Abstract**

A terminal element or bus bar for a power semiconductor module arrangement comprises a first end configured to be arranged inside a housing of the power semiconductor module arrangement, a second end configured to be arranged outside of the housing of the power semiconductor module arrangement, and at least a first section and a second section arranged successively between the first end and the second end along a length of the terminal element or bus bar, wherein either the first section comprises a first material, the second section comprises a second material, and the first material differs from the second material, or the first section has a first thickness, the second section has a second thickness, and the first thickness differs from the second thickness, or both.

## Description

### TECHNICAL FIELD

The instant disclosure relates to a terminal element or bus bar for a power semiconductor module arrangement, and to a semiconductor module arrangement comprising a terminal element or bus bar.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

Electrically conducting terminal elements are usually provided that allow to electrically contact the semiconductor elements from outside of the housing. Such electrically conducting terminal elements may include simple terminal elements as well as bus bars, for example. The terminal elements are configured to provide control signals to the substrate and the components mounted thereon, and the bus bars are configured to provide a supply voltage to the power semiconductor module arrangement. The terminal elements and bus bars, therefore, need to be able to conduct currents. To form a stable mechanical and electrical connection between the substrate and the terminal elements or bus bars, the terminal elements or bus bars are generally soldered or welded to the substrate. Even further, the terminal elements and bus bars often need to be bended at least once, e.g., in order to provide welding surfaces or to properly fit the terminal elements and bus bars into the design of the power semiconductor module arrangement. Therefore, the terminal elements or bus bars may be required to fulfill further requirements.

There is a need for a terminal element or bus bar that fulfills all of the different requirements, and a power semiconductor module arrangement comprising such a terminal element or bus bar.

### SUMMARY

A terminal element or bus bar for a power semiconductor module arrangement includes a first end configured to be arranged inside a housing of the power semiconductor module arrangement, a second end configured to be arranged outside of the housing of the power semiconductor module arrangement, and at least a first section and a second section arranged successively between the first end and the second end along a length of the terminal element or bus bar, wherein either the first section includes a first material, the second section includes a second material, and the first material differs from the second material, or the first section has a first thickness, the second section has a second thickness, and the first thickness differs from the second thickness, or both.

A power semiconductor module arrangement includes a housing, a substrate arranged inside the housing, and at least one terminal element or bus bar, wherein the first end of each of the at least one terminal element or bus bar is arranged inside the housing and electrically and mechanically coupled to the substrate, and the second end of each of the at least one terminal element or bus bar extends to the outside of the housing.

A method for forming a terminal element or bus bar includes joining a first metal sheet to a second metal sheet, thereby forming a large metal sheet including different sections, and stamping a terminal element or bus bar from the large metal sheet including different sections, wherein either the first metal sheet includes a first material, the second metal sheet includes a second material, and the first material differs from the second material, or the first metal sheet has a first thickness, the second metal sheet has a second thickness, and the first thickness differs from the second thickness, or both, and the resulting terminal element or bus bar includes at least one section of the first metal sheet and at least one section of the second metal sheet.

A method for forming a terminal element or bus bar includes providing a metal sheet including a first material, partially reducing the thickness of the metal sheet by means of a milling process, and stamping a terminal element or bus bar from the metal sheet, wherein the resulting terminal element or bus bar includes at least a first section having a first thickness and a second section having a second thickness.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a three-dimensional view of another power semiconductor module arrangement.
Figure 3 is a three-dimensional view of a terminal element according to one example.
Figure 4 is a three-dimensional view of a bus bar according to one example.
Figure 5 schematically illustrates a side view of a terminal element or bus bar according to another example.
Figure 6 schematically illustrates a side view of a terminal element or bus bar according to another example.
Figure 7 schematically illustrates a side view of a terminal element or bus bar according to another example.
Figure 8 schematically illustrates a side view of a terminal element or bus bar according to another example.
Figure 9 schematically illustrates a side view of a terminal element or bus bar according to another example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

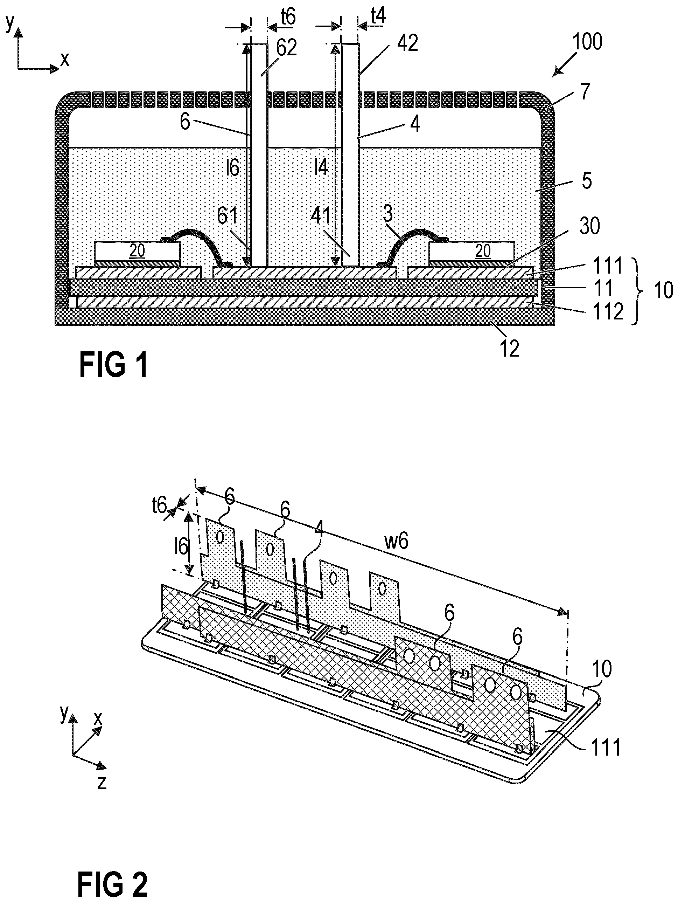

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This is, however, only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. According to another example, the base plate 12 is omitted and the substrate 10 itself forms a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The power semiconductor module arrangement 100 illustrated in Figure 1 further includes terminal elements 4. Only one terminal element 4 is schematically illustrated in Figure 1. A power semiconductor module arrangement 100, however, generally may include a plurality of terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal element 4 illustrated in Figure 1, however, is only an example. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example. For example, the second ends 42 of the terminal elements 4 may be connected to a printed circuit board, for example (not illustrated in Figure 1).

The power semiconductor module arrangement 100 further comprises one or more bus bars 6. Only one bus bar 6 is exemplarily illustrated in Figure 1. A power semiconductor module arrangement 100, however, often comprises two or even more bus bars 6. The terminal elements 4 are generally configured to conduct control signals to and from the substrate 10. Control signals usually comprise electrical signals of 15V or less and are configured to control the function of the different semiconductor bodies 20. It is, however, also necessary to provide supply voltages to the power semiconductor module arrangement 100. The power semiconductor module arrangement 100 switches from an off state (non-working state) to an on state (working state), for example, when a supply voltage is provided. Supply voltages are generally significantly higher with more than 100V, more than 300V, more than 600V and even up to several thousands of volts. The supply voltage can be between 500V and 10kV, or between 600V and 6.5kV, for example. The at least one bus bar 6 is configured to provide such a supply voltage.

The terminal elements 4 generally comprise simple pins, as is exemplarily illustrated in Figure 2. The bus bars 6, on the other hand, in order to be able to provide the significantly higher supply voltages as well as higher currents, have a larger cross-sectional area as compared to the terminal elements 4. According to one example, each of the at least one bus bar 6 comprises a metal sheet. This will be described in further detail below.

The power semiconductor module arrangement 100 may further include an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 and the at least one bus bar 6 may be partly embedded in the encapsulant 5. At least their second ends 42, 62, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

As has been described above, the terminal elements 4 that have to provide comparably small voltages (and currents) generally have a comparably small cross-sectional area. That is, a length 14 of a terminal element 4 between its first end 41 and its second end 42 is generally significantly larger than its greatest thickness (or width) t4. The terminal elements 4 may have a round, oval, square, or rectangular cross-sectional area, for example. That is, the terminal elements 4 may be simple pins, for example. The greatest thickness t4 of a terminal element 4 may be defined by its diameter, its width or a greatest extension in a direction that is perpendicular to the length 14 (e.g., perpendicular to the vertical direction y). In a round terminal element 4, for example, the greatest thickness t4 is defined by the diameter of the terminal element 4, while in a terminal element 4 having a rectangular cross-section, the greatest thickness t4 is defined by the length of the longitudinal sides which are generally longer than the narrow sides. According to one example, each of the at least one terminal element 4 has a length 14 between its first and second end 41, 42 that is at least ten times, at least twenty times, or at least thirty times its greatest thickness t4.

Due to their comparably small cross sectional area, however, the terminal elements 4 may not be able to withstand the much higher supply voltages. A supply voltage, therefore, may be provided by means of bus bars 6. The power semiconductor module arrangement 100 may comprise at least two bus bars 6, for example. One bus bars 6 may be configured to be coupled to a positive potential (e.g., DC+), and another bus bar 6 be configured to be coupled to a negative potential (e.g., DC-). In order to be able to withstand the comparably large supply voltages, each bus bar 6 may have a length 16 and a width w6 that are larger (e.g., at least 10 times larger, at least 30 times larger, or even at least 50 times larger) than a thickness t6 of the bus bar 6 (see, e.g., Figures 1 and 2). A length 16 of a bus bar 6 may be less than ten times, or less than five times the width w6 of the bus bar 6, for example. It is even possible that the width w6 is larger than the length 16 of the bus bar 6, as is schematically illustrated in Figure 2. The width w6 represents the greatest thickness or greatest extension of the bus bar 6 in a direction perpendicular to its length 16, similar to what has been described with respect to the terminal elements 4 above. By significantly increasing the width w6, the cross-sectional area of the bus bars 6 is large (e.g., at least five times, at least ten times, or at least thirty times) as compared to the cross-sectional area of the terminal elements 4. Each of the at least two bus bars 6 comprises a first end 61 that is electrically and mechanically coupled to the substrate 10, and a second end 62 extending to the outside of the housing 7. A thickness t6 of the bus bars 6 may be between 0.5 and 1.5mm (millimeters), e.g., 1mm. The bus bars 6 illustrated is Figures 1 and 2 are straight between their first and second end 61, 62. It is, however, also possible that a bus bar 6 is bent at least once along its length 16.

The terminal elements 4 or bus bars 6 may be required to fulfill a plurality of different requirements. For example, the terminal elements 4, and especially the bus bars 6 may be required to conduct comparably high currents. As has been described above, the cross-sectional area of a terminal element 4 or bus bar 6 may be increased in order to be able to conduct higher currents. The width of the terminal elements 4 and especially the bus bars 6, however, may be limited by the size of the power semiconductor module arrangement. If the thickness t4, t6 of the terminal elements 4 or bus bars 6 is increased, it may be difficult or even impossible to bend the terminal elements 4 or bus bars 6 in a desired form. A greater thickness t4, t6 of the terminal elements or bus bars 6 may result in a large bending radius, which may be an unwanted drawback. A greater thickness t4, t6 of the terminal elements 4 or bus bars 6 may also negatively affect the weldability of the terminal elements 4 or bus bars 6. Therefore, by fulfilling one requirement, this may negatively affect one or more other requirements.

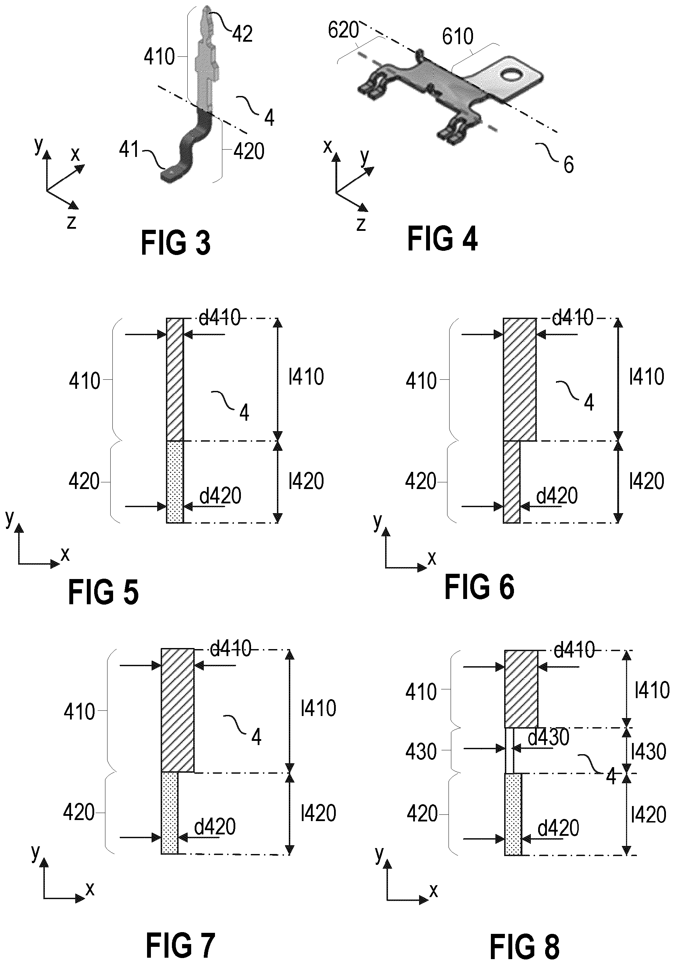

According to one example, therefore, a terminal element 4 or bus bar 6 comprises at least a first section 410, 610 and a second section 420, 620 arranged successively between the first end 41, 61 and the second end 42, 62 along a length 14,16 of the terminal element or bus bar 4, 6. This is schematically illustrated in Figure 3 for a terminal element 4 and in Figure 4 for a bus bar 6. The different sections may comprise different properties. According to a first example, the first section 410, 610 comprises a first material and the second section 420, 620 comprises a second material, wherein the first material differs from the second material. Each of the different materials may fulfill different requirements. For example, a first section 410, 610 may be arranged adjacent to the second end 42, 62, and a second section 420, 620 may be arranged adjacent to the first end 41, 62 of the terminal element 4 or bus bar 6. The first section may comprise a material that is harder than the material of the second section 420, 620. In this way, the second section 420, 620 may be easily bent in order to form welding sections. The first section 410, 610, on the other hand, may be harder and therefore more stable than the second section 420, 620. This may increase the durability and reliability of the terminal elements 4 or bus bars 6. It is also possible that the second section 420, 620 comprising the second material comprises a thermal conductivity that is greater than the thermal conductivity of the first section 410, 610 which comprises the first material. In this way, heat may be conducted away from the substrate 10 to the second section 420, 620. However, it may not be desirable that heat is conducted through the entire terminal elements 4 or bus bars 6 to the outside of the housing 7. This may be prevented by the first section 410, 610 having a lower thermal conductivity. A terminal element 4 comprising a first section 410 and a second section 420 comprising different materials is also schematically illustrated in Figure 5. The first material is indicated by the dashed area 410 and the second material is indicated by the dotted area 420. This may be similarly applied to a bus bar 6.

Additionally or alternatively the first section 410 may have a first thickness d410, and the second section 420 may have a second thickness d420, wherein the first thickness d410 differs from the second thickness d420. This is schematically illustrated in Figure 6, wherein the first thickness d410 is greater than the second thickness d420. The second section 420 may be arranged adjacent to the first end 41 of a terminal element 4 (or bus bar 6). A smaller thickness d420 may allow to more easily bend the first end 41 in order to form a welding area. The first section 410, on the other hand, may have a greater thickness d410 in order to allow to conduct higher currents. The first section 410 and the second section 420 in the example of Figure 6 both comprise the same material, as is indicated by the dashed areas. According to one example, the first thickness d410 may be between 1mm and 1.5mm, and the second thickness d420 may be between 0.5mm and 1mm.

Now referring to Figure 7, it is also possible that the first section 410 comprises a different material and a different thickness d410 than the second section 420. That is, the examples described by means of Figures 5 and 6 above may be combined with each other. While a terminal element 4 is exemplary illustrated in Figure 7, this similarly applies for bus bars 6.

Now referring to Figure 8, it is also possible that the terminal element 4 or bus bar 6 comprises three or even more sections 410, 420, 430 arranged successively between the first end 41 and the second end 42. Additional sections may comprise different materials than the first section 410 and the second section 420. It is, however, also possible that an additional section comprises the first material or the second material. An additional section 430 may comprise a thickness d430 that differs from both the first thickness d410 and the second thickness d420. It is, however, also possible that the thickness d430 of an additional section equals the first thickness d410 and/or the second thickness d420. An additional section 430, however, differs from each of its neighboring sections 410, 420 either by means of its material or by means of its thickness d430.

The terminal elements 4 and bus bars 6 as described above may be specifically tailored to the customer's needs. Two or more sections 410, 420, 430 may be combined in any suitable way. A current flowing from a first end 41, 61 of a terminal element 4 or bus bar 6 to a second end 42, 62 of a terminal element 4 or bus bar 6, or vice versa, passes through at least two different sections 410, 610, 420, 620 comprising different materials and/or different thicknesses d410, d420.

The first material may comprise at least one of copper, aluminum, titanium, and bronze, and the second material may comprise at least one of copper, aluminum, titanium, and bronze. According to one example, the first material comprises a first metal such as, e.g., copper, while the second material comprises a different metal such as, e.g., aluminum. However, according to another example, it is also possible that the first material comprises an alloy of a first metal (e.g., copper), and the second material comprises an alloy of the same metal, wherein an amount of the first metal in the first material differs from an amount of the first metal in the second material. By providing different alloys of the same metal it is also possible to form sections having different properties such as hardness or thermal conductivity, for example.

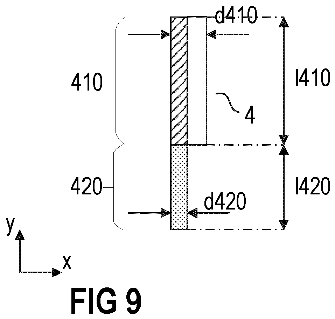

In the examples described above, each section 410, 420, 430 comprises a single layer formed of the respective material. However, it is also possible to achieve different properties of the different sections by providing different layers comprising different materials. This is schematically illustrated in Figure 9. In this example, the second section 420 comprises a single layer comprising the second material. The first section 410, on the other hand, comprises a first layer comprising the first material, and a second layer comprising a third material. The third material may be the same or may differ from the second material of the second section 420. Additional layers may increase the thickness d410 of a section and may provide further characteristics that differ from the characteristics of the other layers of the same section. In this way, the overall properties of the concerned section may be altered. In the example illustrated in Figure 9, the additional layer of the first section 410 does not overlap with the second section 420. This, however, is only an example. It is generally possible that one or more layers of one section overlap with one or more layers of a neighboring section.

Different sections may be connected to each other by means of any suitable method such as, e.g., laser welding. According to one example, in a first step, two or more metal sheets are connected to each other, thereby forming a large metal sheet comprising different sections. The metal sheets may comprise different materials and/or different thicknesses. According to another example, a milling process may be performed instead of or in addition to connecting two or more metal sheets to each other. By means of a milling process, a thickness of one or more sections of a metal sheet may be reduced to a desired thickness. In a subsequent step, the terminal element 6 or bus bar 6 may be formed by means of a stamping process. That is, the desired shape of the terminal element 4 or bus bar 6 may be stamped out of the large metal sheet comprising different sections. The resulting terminal element or bus bar 4, 6 comprises at least one section of the first metal sheet and at least one section of the second metal sheet. If required, the terminal element 4 or bus bar 6 may subsequently be bent into a desired shape.

According to a first example, a method for forming a terminal element or bus bar 4, 6 comprises joining a first metal sheet to a second metal sheet, thereby forming a large metal sheet comprising different sections, and stamping the terminal element or bus bar 4, 6 from the large metal sheet comprising different sections, wherein either the first metal sheet comprises a first material, the second metal sheet comprises a second material, and the first material differs from the second material, or the first metal sheet has a first thickness d410, the second metal sheet has a second thickness d420, and the first thickness d410 differs from the second thickness d420, or both, and the resulting terminal element or bus bar 4, 6 comprises at least one section of the first metal sheet and at least one section of the second metal sheet.

The method may further comprise bending the resulting terminal element 4 or bus bar 6 into a desired shape. The method may further comprise, before stamping the terminal element or bus bar 4, 6 from the large metal sheet comprising different sections, reducing the thickness of at least one section by means of a milling process.

According to a second example, a method for forming a terminal element or bus bar 4, 6 comprises providing a metal sheet comprising a first material, partially reducing the thickness of the metal sheet by means of a milling process, and stamping the terminal element or bus bar 4, 6 from the metal sheet, wherein the resulting terminal element or bus bar 4, 6 comprises at least a first section 410 having a first thickness d410 and a second section 420 having a second thickness d420. The method may further comprise bending the resulting terminal element 4 or bus bar 6 into a desired shape.

## Claims

1. A terminal element or bus bar (4, 6) for a power semiconductor module arrangement (100) comprises:
a first end (41, 61) configured to be arranged inside a housing (7) of the power semiconductor module arrangement (100);
a second end (42, 62) configured to be arranged outside of the housing (7) of the power semiconductor module arrangement (100); and
at least a first section (410, 610) and a second section (420, 620) arranged successively between the first end (41, 61) and the second end (42, 62) along a length (14, 16) of the terminal element or bus bar (4, 6), wherein
either the first section (410) comprises a first material, the second section (420) comprises a second material, and the first material differs from the second material, or
the first section (410) has a first thickness (d410), the second section (420) has a second thickness (d420), and the first thickness (d410) differs from the second thickness (d420),
or both.

2. The terminal element or bus bar (4, 6) of claim 1, wherein
the first material comprises at least one of copper, aluminum, titanium, and bronze; and
the second material comprises at least one of copper, aluminum, titanium, and bronze.

3. The terminal element or bus bar (4, 6) of claim 2, wherein the first material comprises an alloy of a first metal, and the second material comprises an alloy of the same metal, wherein an amount of the first metal in the first material differs from an amount of the first metal in the second material.

4. The terminal element or bus bar (4, 6) of any of the preceding claims, wherein the first material comprises a first hardness, the second material comprises a second hardness, and the first hardness differs from the second hardness.

5. The terminal element or bus bar (4, 6) of any of the preceding claims, wherein
the first thickness (d410) is between 1mm and 1.5mm; and
the second thickness (d420) is between 0.5mm and 1mm.

6. The terminal element or bus bar (4, 6) of any of the preceding claims, wherein the first section (410, 610) comprises a first thermal conductivity, the second section (420, 620) comprises a second thermal conductivity, and the first thermal conductivity differs from the second thermal conductivity.

7. A power semiconductor module arrangement comprising,
a housing (7);
a substrate (10) arranged inside the housing (7); and
at least one terminal element or bus bar (4, 6) according to any of claims 1 to 9, wherein the first end (41, 61) of each of the at least one terminal element or bus bar (4, 6) is arranged inside the housing (7) and electrically and mechanically coupled to the substrate (10), and the second end (42, 62) of each of the at least one terminal element or bus bar (4, 6) extends to the outside of the housing (7).

8. A method for forming a terminal element or bus bar (4, 6) according to any of claims 1 to 6, the method comprising:
joining a first metal sheet to a second metal sheet, thereby forming a large metal sheet comprising different sections;
and stamping the terminal element or bus bar (4, 6) from the large metal sheet comprising different sections, wherein
either the first metal sheet comprises a first material, the second metal sheet comprises a second material, and the first material differs from the second material, or
the first metal sheet has a first thickness (d410), the second metal sheet has a second thickness (d420), and the first thickness (d410) differs from the second thickness (d420),
or both, and
the resulting terminal element or bus bar (4, 6) comprises at least one section of the first metal sheet and at least one section of the second metal sheet.

9. The method of claim 8, further comprising bending the resulting terminal element (4) or bus bar (6) into a desired shape.

10. The method of claim 8 or 9, further comprising, before stamping the terminal element or bus bar (4, 6) from the large metal sheet comprising different sections, reducing the thickness of at least one section by means of a milling process.

11. A method for forming a terminal element or bus bar (4, 6) according to any of claims 1 to 6, the method comprising:
providing a metal sheet comprising a first material;
partially reducing the thickness of the metal sheet by means of a milling process; and
stamping the terminal element or bus bar (4, 6) from the metal sheet, wherein
the resulting terminal element or bus bar (4, 6) comprises at least a first section (410) having a first thickness (d410) and a second section (420) having a second thickness (d420).

12. The method of claim 11, further comprising bending the resulting terminal element (4) or bus bar (6) into a desired shape.

## Amended claims

### Amended claims in accordance with Rule 137(2) EPC.

1. A terminal element or bus bar (4, 6) for a power semiconductor module arrangement (100) comprises:
a first end (41, 61) configured to be arranged inside a housing (7) of the power semiconductor module arrangement (100);
a second end (42, 62) configured to be arranged outside of the housing (7) of the power semiconductor module arrangement (100); and
at least a first section (410, 610) and a second section (420, 620) arranged successively between the first end (41, 61) and the second end (42, 62) along a length (14, 16) of the terminal element or bus bar (4, 6), wherein
the first section (410) comprises a first material, the second section (420) comprises a second material, and the first material differs from the second material.

2. The terminal element or bus bar (4, 6) of claim 1, wherein the first section (410) has a first thickness (d410), the second section (420) has a second thickness (d420), and the first thickness (d410) differs from the second thickness (d420).

3. The terminal element or bus bar (4, 6) of claim 1 or 2, wherein
the first material comprises at least one of copper, aluminum, titanium, and bronze; and
the second material comprises at least one of copper, aluminum, titanium, and bronze.

4. The terminal element or bus bar (4, 6) of claim 3, wherein the first material comprises an alloy of a first metal, and the second material comprises an alloy of the same metal, wherein an amount of the first metal in the first material differs from an amount of the first metal in the second material.

5. The terminal element or bus bar (4, 6) of any of the preceding claims, wherein the first material comprises a first hardness, the second material comprises a second hardness, and the first hardness differs from the second hardness.

6. The terminal element or bus bar (4, 6) of any of the preceding claims, wherein the first thickness (d410) is between 1mm and 1.5mm; and
the second thickness (d420) is between 0.5mm and 1mm.

7. The terminal element or bus bar (4, 6) of any of the preceding claims, wherein the first section (410, 610) comprises a first thermal conductivity, the second section (420, 620) comprises a second thermal conductivity, and the first thermal conductivity differs from the second thermal conductivity.

8. A power semiconductor module arrangement comprising,
a housing (7);
a substrate (10) arranged inside the housing (7); and
at least one terminal element or bus bar (4, 6) according to any of claims 1 to 7, wherein the first end (41, 61) of each of the at least one terminal element or bus bar (4, 6) is arranged inside the housing (7) and electrically and mechanically coupled to the substrate (10), and the second end (42, 62) of each of the at least one terminal element or bus bar (4, 6) extends to the outside of the housing (7).

9. A method for forming a terminal element or bus bar (4, 6) according to any of claims 1 to 7, the method comprising:
joining a first metal sheet to a second metal sheet, thereby forming a large metal sheet comprising different sections;
and stamping the terminal element or bus bar (4, 6) from the large metal sheet comprising different sections, wherein
the first metal sheet comprises a first material, the second metal sheet comprises a second material, and the first material differs from the second material, and
the resulting terminal element or bus bar (4, 6) comprises at least one section of the first metal sheet and at least one section of the second metal sheet.

10. The method of claim 9, further comprising bending the resulting terminal element (4) or bus bar (6) into a desired shape.

11. The method of claim 9 or 10, wherein joining a first metal sheet to a second metal sheet comprises joining a first metal sheet having a first thickness to a second metal sheet having a second thickness that it different from the first thickness.

12. The method of claim 11, further comprising, before stamping the terminal element or bus bar (4, 6) from the large metal sheet comprising different sections, reducing the thickness of at least one section by means of a milling process.
